# EUROPEAN PATENT APPLICATION

(11) **EP 2 579 697 A2**
(43) Date of publication of application: **10.04.2013**
(21) Application number: 12186344.3
(22) Date of filing: 27.09.2012
(51) Int. Cl.: H05K 3/40, H05K 1/03, H05K 7/10

(54) **Interposer, circuit board module, and method for manufacturing interposer**

(30) Priority: 07.10.2011 JP 2011222580
(71) Applicant: FUJITSU LIMITED, Kawasaki-shi, Kanagawa 211-8588 (JP)
(72) Inventor: Moriya, Yasuo, Kanagawa, 211-8588 (JP)
(74) Representative: HOFFMANN EITLE

(57) **Abstract**

An interposer includes a substrate having first and second opposing surfaces, the substrate having a sheet shape; and a plurality of spring electrodes fixed to the substrate in a certain arrangement, each of the plurality of the spring electrodes including a first pad disposed opposite the first surface of the mesh and extending in a first direction, a second pad disposed opposite the second surface of the mesh and extending in the first direction, and a post extending through the substrate between the first and second surfaces and connecting an end of the first pad to an end of the second pad.

## Description

### FIELD

The embodiments discussed herein are related to mounting structures for mounting electronic components on circuit boards.

### BACKGROUND

Circuit board modules are assembled by mounting electronic components, such as semiconductor devices, on printed circuit boards. There are mounting structures proposed to ensure sufficient connection reliability of circuit board modules against a thermal stress occurring in the mounting structures and a strain due to impact. For example, one common structure reinforces solder joints between an electronic component and a printed circuit board by filling the space therebetween (under the electronic component) with a filler such as adhesive. Also available is a resin sealing structure that uses a sealing resin to completely cover an electronic component soldered to a printed circuit board.

The use of a filler or a sealing resin allows an electronic component to be rigidly joined to a printed circuit board. This reduces displacement and strain of the joints due to an external stress, thus maintaining the reliability of the soldering connections.

The rigidly joined electronic component, however, does not allow strain to be released when exposed to an internal stress resulting from the difference in coefficient of thermal expansion between the metal part and the resin part with temperature changes.

Such internal stress might damage the joints. Another problem lies in that the electronic component is removed for repair with a combination of heat and mechanical force, which poses a high risk of damaging surrounding components.

To relieve the stress on the joints, the use of an interposer (intermediate substrate) between the electronic component and the printed circuit board has recently been proposed. The interposer includes springs joining the electronic component to the printed circuit board. These springs absorb the strain on the joints to reduce the stress. For example, an interposer structure is proposed in which lower contact pads are formed at lower ends of vias extending through a substrate, and the portions around the vias are cut into a thin U-shape.

Thin patterns extend along the cut portions to the upper ends of the vias, and upper contact pads are connected to the ends of the patterns. Also proposed is an electrode assembly that holds a plurality of electrodes with a mesh.

Such structures are disclosed in, for example,
[Patent document] Japanese Laid-open Patent Publication No. 2000-77479
[Patent document] Japanese Laid-open Patent Publication No.2005-50782.

The interposer structure in which the portions of the substrate around the vias are cut into a U-shape allows the lower and upper contacts to be aligned in the planar direction of the substrate (X-Y direction).

This structure, however, is not suitable for alignment of the lower and upper contacts in the perpendicular direction (Z direction). A misalignment in the Z direction would tilt the vias, thus resulting in a misalignment of the upper contacts in the X-Y direction.

### SUMMARY

An object of this disclosure is to provide an interposer structure that allows little misalignment of the upper contacts in the X-Y direction and that hold numerous electrode structures capable of relieving the stress exerted by the electronic component and the printed circuit board, and a method for manufacturing such an interposer structure.

According to an aspect of the invention, An interposer includes a substrate having first and second opposing surfaces, the substrate having a sheet shape; and a plurality of spring electrodes fixed to the substrate in a certain arrangement, each of the plurality of the spring electrodes including a first pad disposed opposite the first surface of the mesh and extending in a first direction, a second pad disposed opposite the second surface of the mesh and extending in the first direction, and a post extending through the substrate between the first and second surfaces and connecting an end of the first pad to an end of the second pad.

### BRIEF DESCRIPTION OF DRAWINGS

FIG. 1 is a schematic view of electrode structures of an interposer according to an embodiment;
FIGs. 2A and 2B illustrate the displacement of spring electrodes;
FIG. 3 is a plan view of an interposer according to a first embodiment;
FIG. 4 is a perspective view of the interposer;
FIG. 5 is an enlarged view of part V of FIG. 4;
FIGs. 6A to 6I illustrate a process for manufacturing the interposer;
FIGs. 7A to 7G illustrate another process for manufacturing the interposer;
FIGs. 8A to 8F illustrate a process for filling spaces in the spring electrodes of the interposer with a silicone resin;
FIGs. 9A to 9G illustrate a process for manufacturing an interposer according to a second embodiment; and
FIG. 10 is a table summarizing analytical results of the effect of interposer factor.

### DESCRIPTION OF EMBODIMENTS

Embodiments will now be described with reference to the drawings.

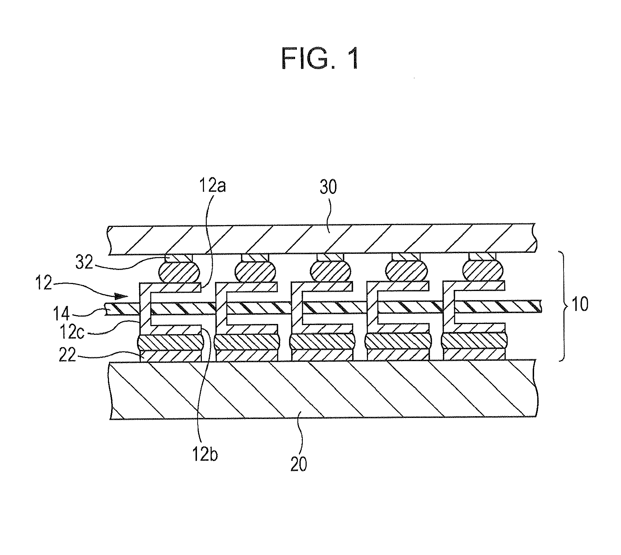

FIG. 1 is a schematic view of electrode structures of an interposer according to an embodiment. An interposer 10 is an intermediate substrate disposed between a circuit board 20 and a semiconductor device 30, which is an electronic component having a plurality of electrodes. The interposer 10 includes a plurality of spring electrodes 12 and a substrate 14 holding the spring electrodes 12. The spring electrodes 12 are soldered to electrode pads 22 of the circuit board 20 and to electrodes 32 of the semiconductor device 30. That is, the electrodes 32 of the semiconductor device 30 are connected to the electrode pads 22 of the circuit board 20 via the spring electrodes 12. Thus, the semiconductor device 30 is mounted on and fixed to the circuit board 20.

The spring electrodes 12 are U-shaped electrodes, each including an upper pad 12a, a lower pad 12b, and a post 12c extending therebetween. The upper pad 12a extends from the upper end of the post 12c, whereas the lower pad 12b extends from the lower end of the post 12c in the same direction as the upper pad 12a, thus forming a U-shape. The electrodes 32 of the semiconductor device 30 are soldered to the upper pads 12a, whereas the electrode pads 22 of the circuit board 20 are soldered to the lower pads 12b.

The spring electrodes 12 are held by the substrate 14 in the same arrangement as the electrodes 32 of the semiconductor device 30. With the interposer 10 placed and positioned between the semiconductor device 30 and the circuit board 20, the electrodes 32 of the semiconductor device 30 may be connected to the corresponding electrode pads 22 of the circuit board 20 via the spring electrodes 12 of the interposer 10 by soldering.

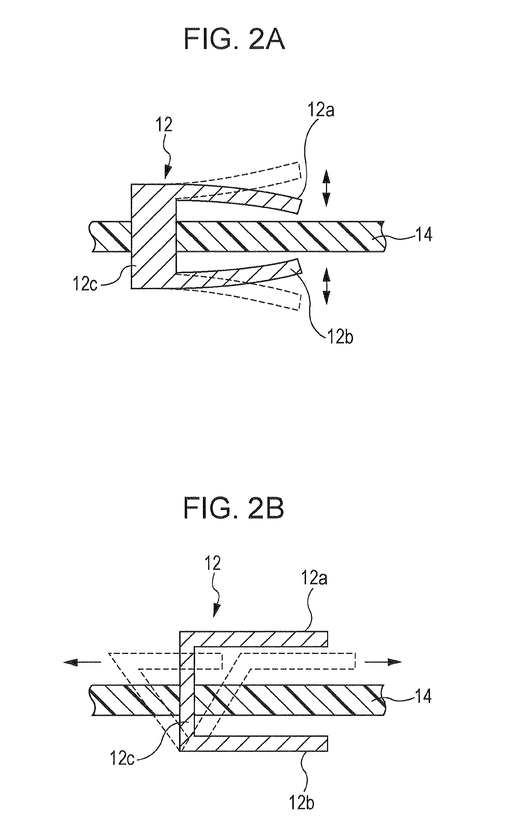

The upper pads 12a of the spring electrodes 12 are spaced apart from the substrate 14. As illustrated in FIG. 2A, the upper pads 12a may be tilted with respect to the upper ends of the posts 12c. Similarly, the lower pads 12b of the spring electrodes 12 are spaced apart from the substrate 14. As illustrated in FIG. 2A, the lower pads 12b may be tilted with respect to the lower ends of the posts 12c. Thus, the upper pads 12a and the lower pads 12b may be displaced in the perpendicular direction (Z direction) while being supported by the posts 12c. Accordingly, the solder joints between the upper pads 12a and the electrodes 32 of the semiconductor device 30 may be displaced in the Z direction. Similarly, the solder joints between the lower pads 12b and the electrode pads 22 of the circuit board 20 may be displaced in the Z direction. This allows the spring electrodes 12 to be elastically deformed to relieve an external force or thermal stress acting on the solder joints, thus maintaining the reliability of the joints.

As illustrated in FIG. 2B, the posts 12c of the spring electrodes 12 may be made thinner so that they may be tilted. This allows the upper pads 12a and the lower pads 12b to be displaced relative to each other in parallel in the planar direction (X-Y direction). When a force is exerted in the X-Y direction between the semiconductor device 30 and the circuit board 20, the upper pads 12a and lower pads 12b of the spring electrodes 12 are displaced relative to each other in the planar direction. This reduces the stress exerted on the solder joints, thus maintaining the reliability of the joints.

As noted above, the spring electrodes 12 are joined to the substrate 14 in a predetermined arrangement. The substrate 14 may be any sheet member that may hold the centers of the posts 12c of the spring electrodes 12, for example, an insulating resin sheet. However, as described later, the use of a mesh woven from fibers as the substrate 14, with the spring electrodes 12 formed such that they extend through the substrate 14, facilitates formation of the substrate 14 having the spring electrodes 12 joined thereto.

An interposer according to a first embodiment will now be described.

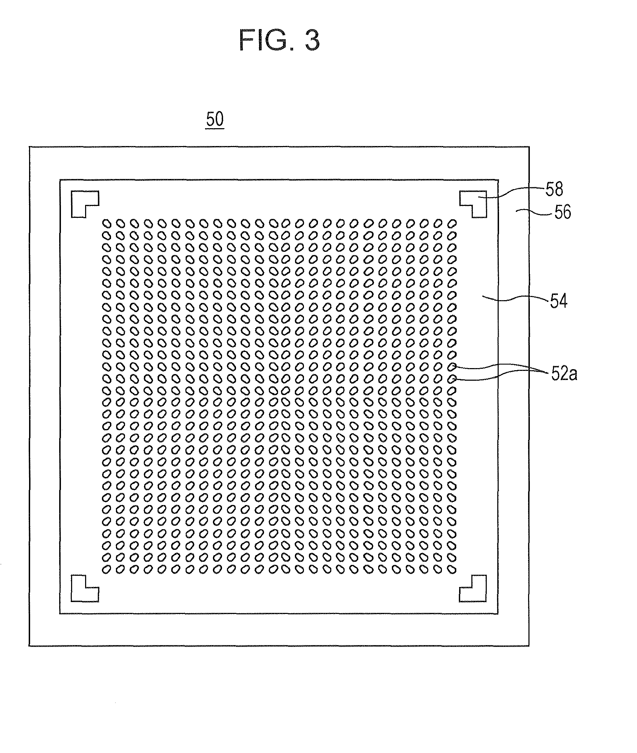

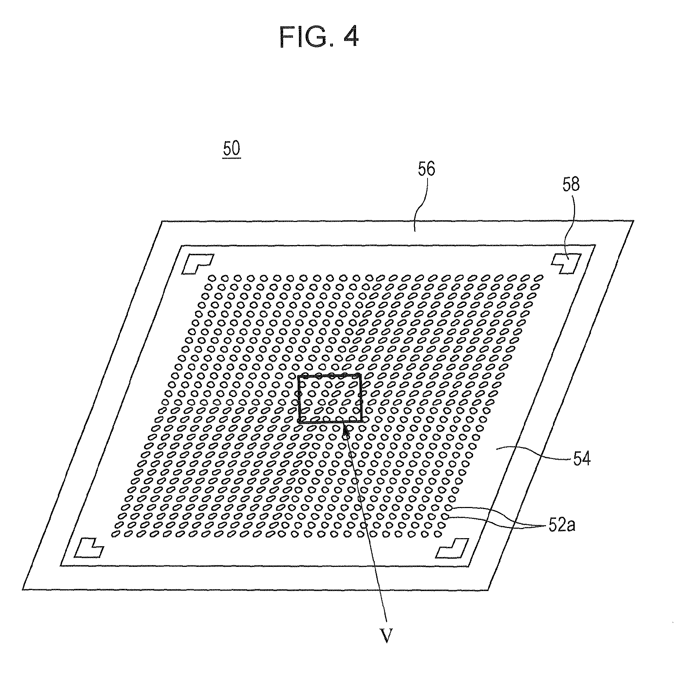

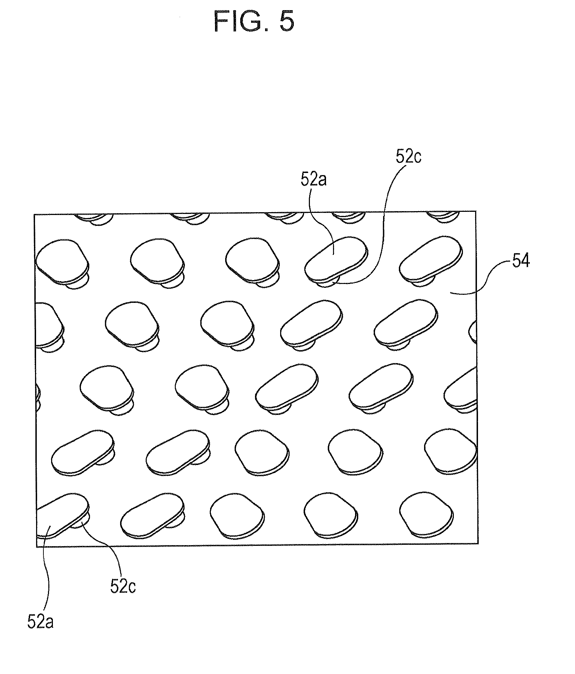

FIG. 3 is a plan view of an interposer 50 according to the first embodiment. FIG. 4 is a perspective view of the interposer 50. FIG. 5 is an enlarged view of part V of FIG. 4.

The interposer 50 includes numerous spring electrodes 52 and a mesh 54 that holds the spring electrodes 52. The spring electrodes 52 are joined to and held by the mesh 54 in a predetermined arrangement. The predetermined arrangement is identical to the arrangement of the electrodes 32 of the semiconductor device 30 mounted on the circuit board 20. In this embodiment, the semiconductor device 30 has the electrodes 32 arranged over the entire surface thereof, and accordingly the interposer 50 has the spring electrodes 52 arranged over the entire surface thereof.

The mesh 54, which is the substrate of the interposer 50, is a fabric sheet woven from liquid crystal polymer fibers coated with a heat-resistant resin such as polyethylene naphthalate. The mesh 54 is rectangular, matching the shape of the semiconductor device 30. The mesh 54 has a frame 56 surrounding the four sides thereof. The frame 56 functions to keep the mesh 54 flat. The frame 56 may be formed of the same material as the spring electrodes 52, such as copper or nickel, or may be formed of other rigid materials. For example, the frame 56 may be formed of a resin such as epoxy resin or bismaleimide resin. Being relatively rigid, the frame 56 surrounding the mesh 54, which is flexible, keeps it flat. The use of the same material as the spring electrodes 52 allows the frame 56 to be simultaneously formed in the step of forming the spring electrodes 52.

Mounting indicator marks 58 are provided at the four corners inside the frame 56. The mounting indicator marks 58 are preferably formed of the same material as the spring electrodes 52, such as copper or nickel. The use of the same material as the spring electrodes 52 allows the mounting indicator marks 58 to be simultaneously formed in the step of forming the spring electrodes 52.

For example, a frame 56 and mounting indicator marks 58 formed of a metal such as copper or nickel may be joined to dummy electrode pads formed on the circuit board 20 to enhance the joining of the interposer 50 and the circuit board 20. Alternatively, in addition to the frame 56 and the mounting indicator marks 58, a metal pattern may be formed outside the region where the spring electrodes 52 are formed and be joined to the dummy electrode pads formed on the circuit board 20.

The spring electrodes 52 are U-shaped electrodes, each including the post 52c extending through the mesh 54 and the upper pad 52a and lower pad 52b formed at either end of the post 52c. The spring electrodes 52 are arranged over the entire region inside the mounting indicator marks 58. FIGs. 3 to 5 illustrate the top surface of the interposer 50, where the upper pads 52a are seen. The lower pads 52b are disposed on the backside of the interposer 50 and are not seen in FIGs. 3 to 5.

The spring electrodes 52 have a U-shape similar to that of the spring electrodes 12 illustrated in FIG. 1. The upper pads 52a and the lower pads 52b have a slightly elongated oval shape, each having the post 52c connected to one end thereof (small-diameter portion) and a pad portion formed at the other end thereof (large-diameter portion). The pad portions are joined to the electrodes 32 of the semiconductor device 30 and the electrode pads 22 of the circuit board 20. When an external force is exerted on the joints, the posts 52c may bend easily, and the upper pads 52a and the lower pads 52b themselves may also bend easily while being supported by the posts 52c.

The upper pad 52a and lower pad 52b of each spring electrode 52, which has a U-shaped cross-section, extend from the post 52c in the same direction. The upper pads 52a and the lower pads 52b extend in outward directions away from the center (inside) of the mesh 54. During thermal expansion, the interposer 50 expands in outward directions away from the center. The displacement of the interposer 50 becomes larger in the directions in which it expands. Accordingly, the thermal stress on the interposer 50 becomes larger in the directions in which it expands. The upper pads 52a and lower pads 52b of the spring electrodes 52 tend to be displaced in the directions in which they extend. Thus, the directions in which the upper pads 52a and the lower pads 52b extend match the directions in which the interposer 50 expands. This effectively relieves the thermal stress due to thermal expansion.

The portions of the upper pads 52a and lower pads 52b of the spring electrodes 52 extending from the portions connected to the posts 52c are formed as pads. The center of the portions to be actually soldered is separated from the portions connected to the posts 52c by a predetermined distance. For example, if the distance between the center of the portions to be soldered of the upper pads 52a and the portions connected to the posts 52c is smaller than the diameter of the solder balls with which they are joined together, the entire upper pads 52a are soldered, which makes them less flexible and less easily deformable. If the center of the portions to be actually soldered is separated from the portions connected to the posts 52c by a predetermined distance (i.e., a distance equal to the radius of the solder balls with which they are joined together), the solder does not cover the entire upper pads 52a, i.e., from the soldered portions to the posts 52c. This keeps the upper pads 52a flexible and easily displaceable.

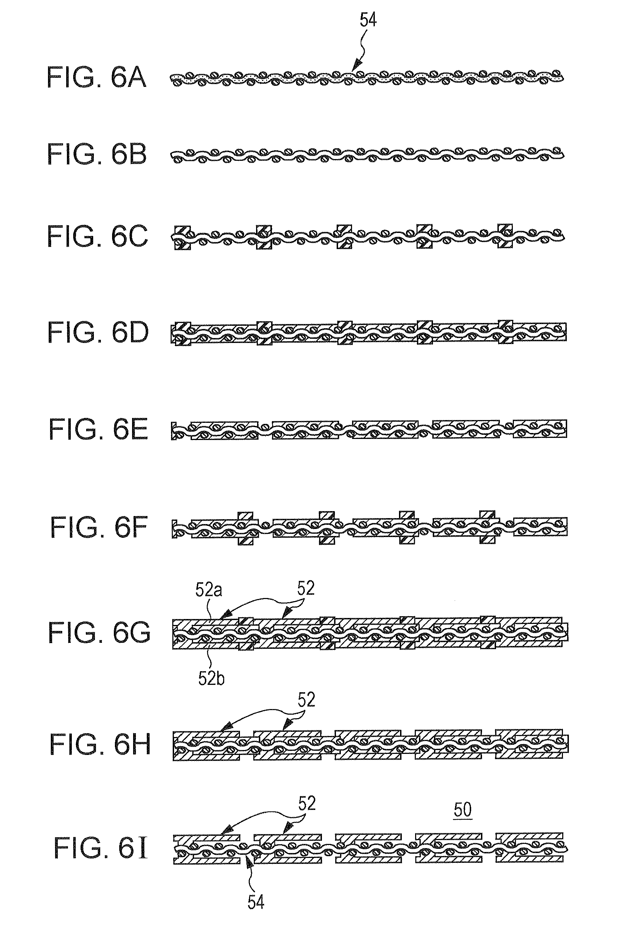

A method for manufacturing the interposer 50 will now be described. FIGs. 6A to 6I illustrate a process for manufacturing the interposer 50.

Referring now to FIG. 6A, a mesh cloth is provided as the mesh 54. The mesh cloth, as noted above, is a fabric sheet woven from liquid crystal polymer fibers coated with a heat-resistant resin such as polyethylene naphthalate. FIG. 6A illustrates a cross-section of the mesh cloth, where the wavy line indicates weft and the oval cross-sections indicate warp. The mesh cloth is preferably annealed at, for example, 235°C to remove any internal stress from the fibers for improved flatness.

Turning to FIG. 6B, the entire mesh cloth is subjected to electroless plating with, for example, nickel. Turning to FIG. 6C, a resist is formed so as to cover the positions where the posts 52c are to be formed. Turning to FIG. 6D, the mesh cloth is subjected to copper electroplating to form a copper layer in the region where the resist is not formed. Turning to FIG. 6E, the resist is removed, leaving the copper layer.

Turning to FIG. 6F, a resist is formed on the top and bottom surfaces of the mesh cloth so as to define the shapes of the upper pads 52a and the lower pads 52b. That is, a resist is formed in the region where the upper pads 52a and the lower pads 52b are not to be formed.

Turning to FIG. 6G, the entire mesh cloth is subjected to nickel electroplating to form the spring electrodes 52 joined to the mesh cloth. The nickel layer fills the regions from which the resist initially formed has been removed (see FIG. 6E) to form the posts 52c of the spring electrodes 52. The posts 52c extend through holes in the mesh cloth (gaps between the fibers) between the top and bottom of the mesh cloth. The posts 52c are fixed to the mesh cloth, with the centers thereof embedded therein.

The nickel layer also fills the regions where the resist is not formed on the top and bottom surfaces of the mesh cloth (see FIG. 6F) to form the upper pads 52a and lower pads 52b of the spring electrodes 52. The upper pads 52a are formed on the top surface of the mesh cloth, whereas the lower pads 52b are formed on the bottom surface of the mesh cloth. The upper pads 52a and the lower pads 52b are connected together with the posts 52c extending through the mesh cloth.

After the spring electrodes 52 are formed by nickel electroplating, the resist is removed from the top and bottom surfaces of the mesh cloth. Turning to FIG. 6H, thus, the nickel layer forming the spring electrodes 52 and the copper layer covering the mesh cloth remain on the mesh cloth.

Turning to FIG. 6I, finally, the copper layer is removed by etching. Thus, the interposer 50 is completed. Removing the copper layer leaves spaces between the upper pads 52a and the mesh cloth and between the lower pads 52b and the mesh cloth. This allows the upper pads 52a and the lower pads 52b to bend easily and to be displaced in the Z direction. Also, the portions of the posts 52c other than the centers thereof may bend because only the centers are fixed to the mesh cloth. Thus, the upper pads 52a and the lower pads 52b are displaceable in the X-Y direction as well as the Z direction.

As discussed above, the use of a mesh cloth as the mesh 54 facilitates formation of a plurality of spring electrodes joined together by a substrate. In the nickel electroplating step described above, the frame 56 and the mounting indicator marks 58 illustrated in FIGs. 3 and 4 may be formed at the same time.

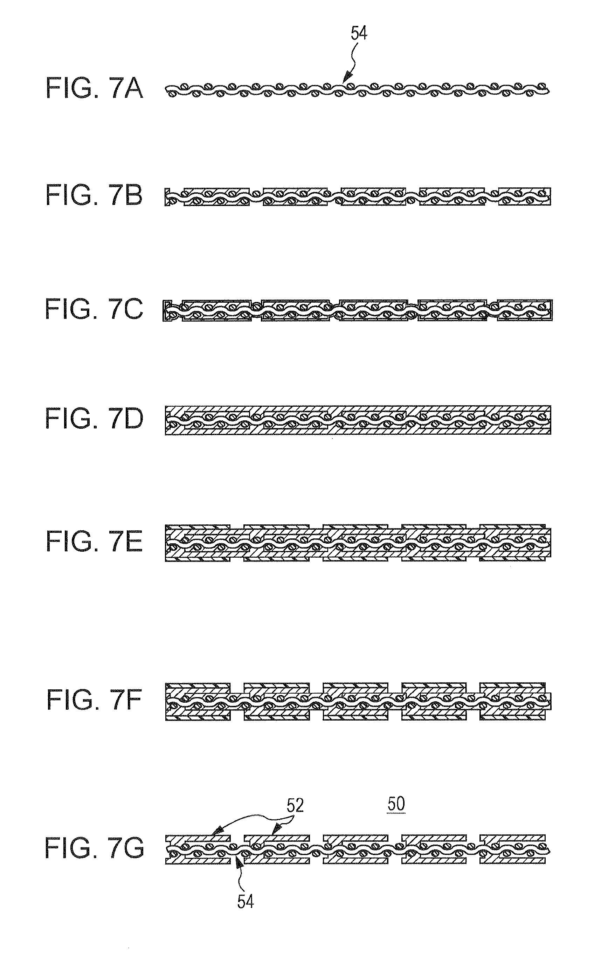

Another method for manufacturing the interposer 50 will now be described. FIGs. 7A to 7G illustrate another process for manufacturing the interposer 50.

Referring now to FIG. 7A, a mesh cloth is provided as the mesh 54. This step is similar to the step illustrated in FIG. 6A. The mesh cloth is preferably annealed at, for example, 235°C to remove any internal stress from the fibers for improved flatness.

Turning to FIG. 7B, a resist is formed on the mesh cloth in the region where the posts 52c of the spring electrodes 52 are not to be formed. Turning to FIG. 7C, the entire mesh cloth is subjected to electroless copper plating to form a copper seed layer on the surfaces of the resist and on the exposed portions of the mesh cloth.

Turning to FIG. 7D, copper electroplating is performed on the copper seed layer to form a copper layer on the top and bottom surfaces of the mesh cloth. The copper layer fills holes in the mesh cloth (gaps between the fibers) to form the posts 52c in the regions where the resist is not formed. The portions of the copper layer formed on the resist are the portions that are to form the upper pads 52a and the lower pads 52b.

Turning to FIG. 7E, a resist is formed on the top of the copper layer in the pattern corresponding to the upper pads 52a and on the bottom of the copper layer in the pattern corresponding to the lower pads 52b. Turning to FIG. 7F, the copper layer is etched using the resist as a mask to remove the portion of the copper layer not covered by the resist. Turning to FIG. 7G, the resist remaining on the copper layer and the resist initially formed on the mesh cloth are removed. Thus, the interposer 50 is completed.

The above interposer 50 has spaces between the upper pad 52a and the mesh 54 and between the lower pads 52b and the mesh 54, so that the upper pads 52a and the lower pads 52b are easily displaceable. Alternatively, these spaces may be filled with a flexible material. An example of such a flexible material is silicone resin.

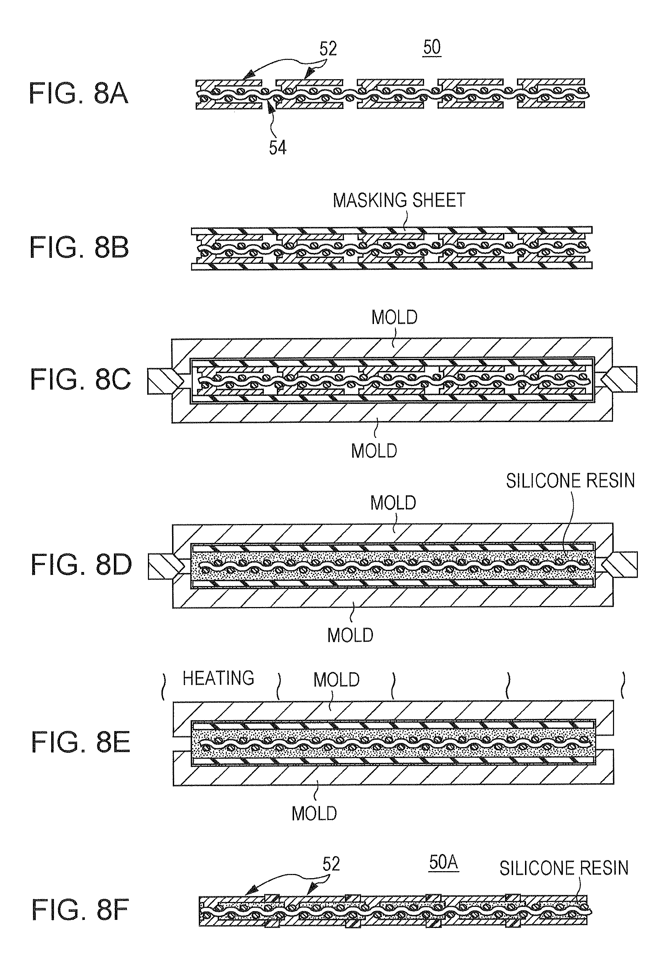

IGs. 8A to 8F illustrate a process for filling the spaces in the spring electrodes 52 of the interposer 50 with a silicone resin. Referring now to FIG. 8A, the interposer 50 is formed by the process as illustrated in FIGs. 6A to 6I or FIGs. 7A to 7G. Turning to FIG. 8B, masking sheets are laminated over the upper pads 52a and lower pads 52b of the spring electrodes 52.

Turning to FIG. 8C, the interposer 50 having the masking sheets laminated thereon is placed in a mold. Turning to FIG. 8D, a silicone resin is injected into the mold. The silicone resin fills the spaces between the upper pad 52a of the spring electrodes 52 and the mesh 54 and the spaces between the lower pads 52b of the spring electrodes 52 and the mesh 54. Turning to FIG. 8E, the mold is heated to cure the silicone resin injected into the mold.

Turning to FIG. 8F, after the silicone resin is cured, the interposer 50 is removed from the mold. Thus, an interposer 50A is obtained. The interposer 50A has the silicone resin filling the spaces between the upper pad 52a and the mesh 54 and the spaces between the lower pads 52b and the mesh 54.

The silicone resin, having high flexibility, has little impact on bending (displacement) of the upper pads 52a and the lower pads 52b. Thus, the spring electrodes 52 of the interposer 50A provide the same effect as those of the interposer 50 illustrated in FIG. 6I or 7G.

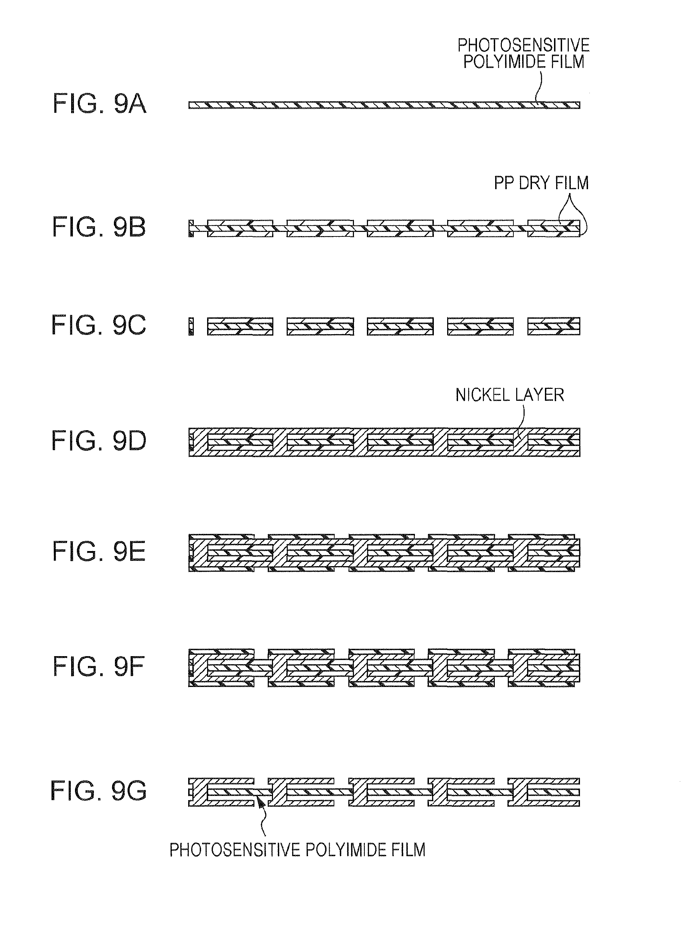

An interposer according to a second embodiment will now be described. An interposer 60 according to the second embodiment is similar to the interposer 50 except that the mesh 54 is replaced by a polyimide film. The description herein will focus on a method for manufacturing the interposer 60. FIGs. 9A to 9G illustrate a process for manufacturing the interposer 60.

Referring now to FIG. 9A, a photosensitive polyimide film is provided. Turning to FIG. 9B, polypropylene (PP) dry films are laminated on both surfaces of the photosensitive polyimide film. These PP dry films have openings of the same shape as the cross-section of the posts 52c of the spring electrodes 52 at the positions where the posts 52c are to be formed.

Turning to FIG. 9C, the photosensitive polyimide film is exposed and developed through the openings of the PP dry films to form through-holes. A copper seed layer is then formed over the entire surfaces of the PP dry films by sputtering. Turning to FIG. 9D, nickel electroplating is performed on the copper seed layer to form a nickel layer. The nickel layer covers the PP dry films.

Turning to FIG. 9E, a resist is formed on the top surface of the nickel layer in the same pattern as the upper pads 52a and on the bottom surface of the nickel layer in the same pattern as the lower pads 52b. Turning to FIG. 9F, the nickel layer is etched using the resist as a mask. Thus, the upper pads 52a and the lower pads 52b are formed under the resist.

Turning to FIG. 9G, finally, the resist and the PP dry films are removed. Thus, the interposer 60 is completed. Removing the PP dry films from between the photosensitive polyimide film and the upper pads 52a and between the photosensitive polyimide film and the lower pads 52b leaves spaces between the photosensitive polyimide film and the upper pads 52a and between the photosensitive polyimide film and the lower pads 52b. This allows the upper pads 52a and the lower pads 52b to bend easily under an external force, thereby relieving a stress exerted on the joints.

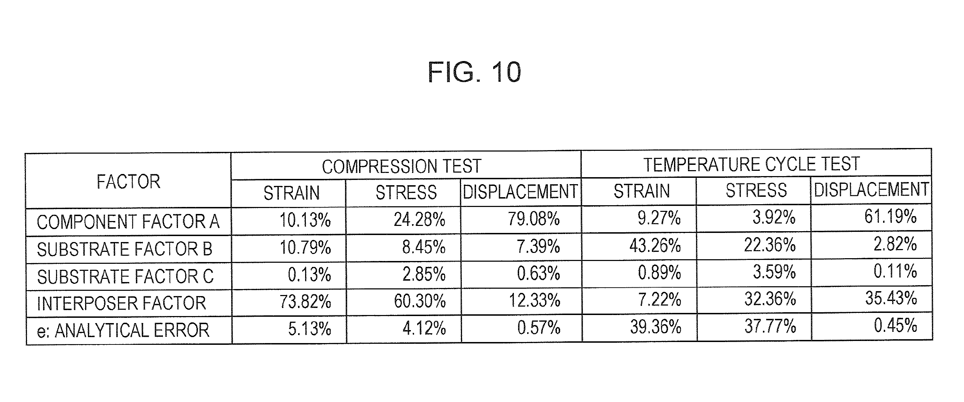

The effect provided by the use of the interposer 50 described above was examined by performing a simulation. In this simulation, eight structural models were created with varying levels of component and substrate design specifications. A predetermined compression test and a predetermined temperature cycle test were simulated to calculate the displacement, stress, and strain of joints. An analysis of variance of the calculations was then performed to calculate the percent contribution of the interposer 50 according to this embodiment. Thus, the percent contributions of the interposer 50 to displacement, stress, and strain (i.e., the effect of the interposer 50) were determined. FIG. 10 summarizes the analytical results of the effect of the interposer factor determined by the simulation.

In FIG. 10, component factor A is the size of a chip mounted on a substrate. A large chip size was set to level 1, whereas a small chip size was set to level 2. Substrate factor B is the thickness of a substrate. A thick substrate was set to level 1, whereas a thin substrate was set to level 2. Substrate factor C is the pitch of pads of a substrate. A large pitch was set to level 1, whereas a small pitch was set to level 2. The interposer factor is whether the interposer is provided or not. The case where no interposer was provided was set to level 1, whereas the case where the interposer was provided was set to level 2.

The above eight levels of factors were combined according to an L8 orthogonal table matrix to create eight structural models. For each structural model, a predetermined compression test and a predetermined temperature cycle test were simulated to calculate the displacement, stress, and strain of joints.

The structural models created by combining the eight levels of factors according to an L8 orthogonal table matrix were as follows:

Model 1: Small chip size (level 1)
   Thick substrate (level 1)
   Large pad pitch (level 1)
   No interposer provided (level 1)
Model 2: Small chip size (level 1)
   Thick substrate (level 1)
   Large pad pitch (level 1)
   Interposer provided (level 2)
Model 3: Small chip size (level 1)
   Thin substrate (level 2)
   Small pad pitch (level 2)
   No interposer provided (level 1)
Model 4: Small chip size (level 1)
   Thin substrate (level 2)
   Small pad pitch (level 2)
   Interposer provided (level 2)
Model 5: Large chip size (level 2)
   Thick substrate (level 1)
   Small pad pitch (level 2)
   No interposer provided (level 1)
Model 6: Large chip size (level 2)
   Thick substrate (level 1)
   Small pad pitch (level 2)
   Interposer provided (level 2)
Model 7: Large chip size (level 2)
   Thin substrate (level 2)
   Large pad pitch (level 1)
   No interposer provided (level 1)
Model 8: Large chip size (level 2)
   Thin substrate (level 2)
   Large pad pitch (level 1)
   Interposer provided (level 2)

In the compression test, both ends of the substrate were fixed, and a load was applied to the substrate by pressing a bar having a diameter of 6 mm against the center of the back surface of the substrate to calculate the displacement, stress, and strain of the joints. In the temperature cycle test, a temperature cycle in which each structural model was heated from 25°C to 125°C, was cooled to -40°C, and was returned to 25°C in 30 minutes was performed three times to calculate the displacement, stress, and strain of the joints for each cycle.

FIG. 10 summarizes the percent contributions of the individual factors to displacement, stress, and strain calculated by performing an analysis of variance of the displacement, stress, and strain of joints for each structural model obtained by the compression test and the temperature cycle test. FIG. 10 also contains analytical errors involved in the calculation of the percent contributions.

The interposer according to this embodiment is intended to reduce local concentration of a load on solder joints. The percent contributions noted above indicate the effect of reducing variation due to a load on the joints (i.e., improving stability) attributed to the interposer factor.

As summarized in FIG. 10, the percent contribution of the interposer factor to strain in the compression test was 73.82%, demonstrating that the variation-reducing effect produced by the interposer according to this embodiment was 73.82%. Also, the variation-reducing effect on stress was 60.3%, and the variation-reducing effect on displacement was 12.33%. The predominant factor in displacement was component factor A (chip size factor).

The percent contribution of the interposer factor to strain in the temperature cycle test was 7.22%, demonstrating that the variation-reducing effect produced by the interposer according to this embodiment was 7.22%. Also, the variation-reducing effect on stress was 32.3%, and the variation-reducing effect on displacement was 35.43%.

As discussed above, the simulation demonstrated that the interposer according to this embodiment, when used to mount an electronic component on a substrate, reduces a load (e.g., strain, stress, and displacement) on solder joints due to market variation factors (e.g., usage and ambient temperature changes).

## Claims

1. An interposer comprising:
a substrate having first and second opposing surfaces, the substrate having a sheet shape; and
a plurality of spring electrodes fixed to the substrate in a certain arrangement, each of the plurality of the spring electrodes including
a first pad disposed opposite the first surface of the mesh and extending in a first direction,
a second pad disposed opposite the second surface of the mesh and extending in the first direction, and
a post extending through the substrate between the first and second surfaces and connecting an end of the first pad to an end of the second pad.

2. The interposer according to Claim 1, wherein the substrate is a mesh sheet having holes through which the posts of the spring electrodes extend between the first and second surfaces.

3. The interposer according to Claim 2, wherein the mesh is a mesh cloth woven from fibers.

4. The interposer according to Claim 1, wherein the substrate is a resin film through which the posts of the spring electrodes extend between the first and second surfaces.

5. The interposer according to claim 1, wherein the first pads and the substrate have spaces therebetween, and the second pads and the substrate have spaces therebetween.

6. The interposer according to Claim 5, further comprising a flexible material filling the spaces between the first pads and the substrate and the spaces between the second pads and the substrate.

7. The interposer according to Claim 6, wherein the flexible material is a silicone resin.

8. The interposer according to claim 1, wherein each of the first pads includes a portion to be joined whose center is separated from a portion of the first pad connected to the post by a predetermined distance or more, and each of the second pads includes a portion to be joined whose center is separated from a portion of the second pad connected to the post by a predetermined distance or more.

9. The interposer according to claim 1, wherein the first direction is an outward direction away from the center of the substrate.

10. The interposer according to claim 1, further comprising a frame surrounding the substrate.

11. The interposer according to claim 1, further comprising a metal pattern outside a region where the spring electrodes are arranged on the first surface of the substrate.

12. A circuit board module comprising:
a circuit board;
an electronic component; and
a electronic component being mounted on the circuit board with a interposer that is between the electronic component and the circuit board, wherein
the interposer includes:
a substrate having first and second opposing surfaces, the substrate having a sheet shape; and
a plurality of spring electrodes fixed to the substrate in a certain arrangement, each of the plurality of the spring electrodes including
a first pad disposed opposite the first surface of the mesh and extending in a first direction,
a second pad disposed opposite the second surface of the mesh and extending in the first direction, and
a post extending through the substrate between the first and second surfaces and connecting an end of the first pad to an end of the second pad.

13. A method for manufacturing an interposer, comprising:
forming a copper layer on a mesh in a region other than predetermined regions by plating, the mesh having first and second opposing surfaces; and
forming metal posts in the predetermined regions by nickel plating, the metal posts extending through holes in the mesh between the first and second surfaces of the mesh, and forming first pads and second pads by nickel plating, the first pads extending from the metal posts along the copper layer opposite the first surface of the mesh, the second pads extending from the metal posts along the copper layer opposite the second surface of the mesh.

14. The method for manufacturing an interposer according to Claim 13, further comprising, after the forming of the first pads and the second pads, removing the copper layer by etching to form spaces between the first pads and the mesh and between the second pads and the mesh.

15. A method for manufacturing an interposer, comprising:
forming a first resist on a mesh in a region other than predetermined regions, the mesh having first and second opposing surfaces; and
forming metal posts in the predetermined regions by metal plating, the metal posts extending through holes in the mesh between the first and second surfaces of the mesh, and forming a metal layer by metal plating, the metal layer extending from the metal posts along the first resist opposite the first surface of the mesh and extending from the metal posts along the first resist opposite the second surface of the mesh.

16. The method for manufacturing an interposer according to Claim 15, further comprising:
forming a second resist on each surface of the metal layer;
removing a portion of the metal layer by etching using the second resist as a mask to form first pads and second pads; and
removing the first resist and the second resist to form spaces between the first pads and the first surface of the mesh and between the second pads and the second surface of the mesh.

17. A method for manufacturing an interposer, comprising:
laminating resist films on first and second opposing surfaces of a resin sheet and forming through-holes at predetermined positions;
forming a metal layer in the through-holes and on the entire surfaces of the resist films by plating;
etching the metal layer to form first pads and second pads; and
removing the resist films to form spaces between the first pads and the first surface of the resin sheet and between the second pads and the second surface of the resin sheet.
